# EUROPEAN PATENT APPLICATION

(11) **EP 3 951 885 A1**
(43) Date of publication of application: **09.02.2022**
(21) Application number: 20189541.4
(22) Date of filing: 05.08.2020
(51) Int. Cl.: H01L 29/78, H01L 29/423, H01L 21/336

(54) **A SEMICONDUCTOR DEVICE AND A METHOD OF MANUFACTURE OF A SEMICONDUCTOR DEVICE**

(71) Applicant: Nexperia B.V., 6534 AB Nijmegen (NL)
(72) Inventor: Peake, Steven, 6534 AB Nijmegen (NL); Rutter, Phil, 6534 AB Nijmegen (NL)
(74) Representative: Pjanovic, Ilija

(57) **Abstract**

This disclosure relates to a semiconductor device, which semiconductor device comprises a gate electrode, the gate electrode comprising an upper side and a bottom side, a dielectric oxide on the upper side of the gate electrode and a deposited oxide on the bottom side of the gate electrode, wherein the deposited oxide has a first width. Between the deposited oxide and the gate electrode a thermal oxide region is located, wherein the thermal oxide region has a second width, wherein the second width of the thermal oxide region is broader than the first width of the deposited oxide.

## Description

### FIELD

The present invention relates to a semiconductor device. The invention also relates to a method of manufacturing of a semiconductor device.

### BACKGROUND

Power metal-oxide-semiconductor field-effect transistors (MOSFET) are known in the art. A power MOSFET is a specific type of MOSFET designed to handle higher power levels. Compared to the other power semiconductor devices, such as an insulated-gate bipolar transistor (IGBT) or a thyristor, the main advantages of the power MOSFET devices are high switching speed and good efficiency at low voltages. It shares with the IGBT an isolated gate that makes it easy to drive. They can be subject to low gain, sometimes to a degree that the gate voltage needs to be higher than the voltage under control.

The design of power MOSFETs was made possible by the evolution of MOSFET and complementary metal-oxide-semiconductor (CMOS) technology which is used for manufacturing of integrated circuits. The power MOSFET has similar operating principle as a low-power counterpart, a lateral MOSFET.

Lateral reduced surface field (RESURF) devices are also known in the art. The low on-resistance and the high breakdown voltage (BV) in lateral RESURF devices make them desirable for use in high voltage integrated circuit (HVIC) technologies. Although desirable, RESURF devices suffer from the unique requirement of accurate charge control and they are very sensitive to charge balance. Variations on charge control may lead to a lower BV causing limitations on the device performance. This control requirement complicates the manufacturability of RESURF devices. It is rather difficult to obtain a BV that is reproducible in fabrication.

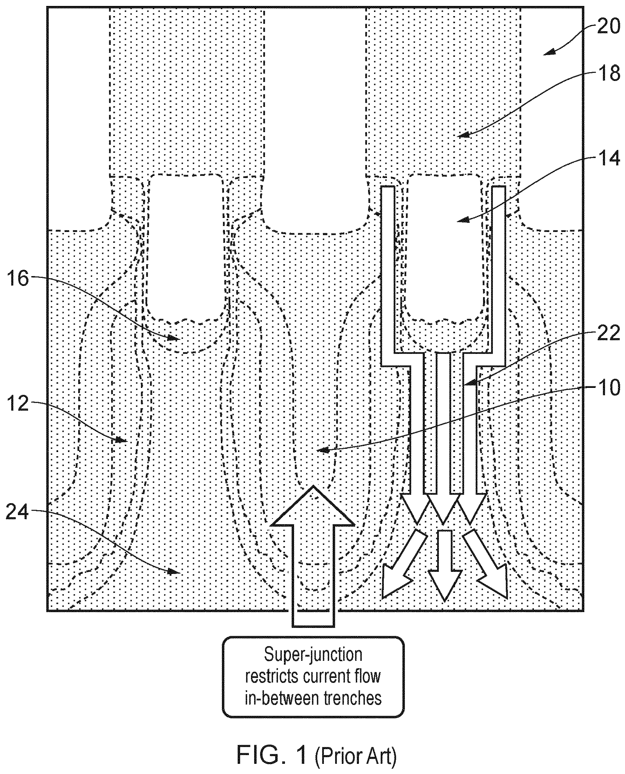

A know device based on super junction technologies is shown in Figure 1. It can achieve RESURF by depleting an n-type epi 12 between two deep p-type super junction pillars 10. The extent/depth of the super junction pillars determine the breakdown voltage of the device. Such a device also comprises a gate electrode 14 of n-type polysilicon, a thick oxide 16 grown thermally on the bottom side of the gate electrode 14, and thick oxide dielectric layer 18 on the upper side of the gate electrode 14. The thickness of the thick oxide dielectric layer 18 can be in a range between 400nm to 800nm. The device further comprises a source metallization 20. Electron flow lines 22 and current flowlines 24 are also shown in Figure 1.

Such a super junction restricts current flow in the epi region between the deep p-type super junction pillars 10. The presence of the deep super junction p-type pillars creates low drain-source voltage (Vds) depletion regions that extends into the n-type epi and current cannot flow in these regions. For example: for a 1.5µm cell pitch, less than a third of the total cell is open to current flow.

Further reductions in cell pitch offer little benefit as higher cell density is out-weighed by the further restriction or so-called current pinching in-between the super junction deep p-type regions.

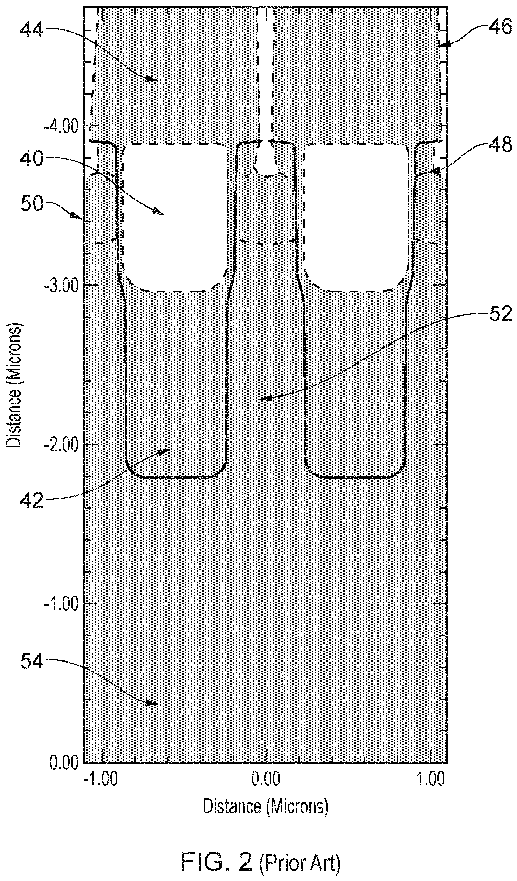

Figure 2 illustrates a device known in the art. In this case the super junction pillars are omitted and the RESURF is achieved by utilizing the area under the trench.

Such a device comprises a gate electrode 40 made of n-type polysilicon, a deposited oxide region 42 at the bottom side of the gate electrode 40, and an oxide dielectric layer 44 on the upper side of the gate electrode 40. There is a source metallisation 46 around the oxide dielectric layer 44. The device further comprises a n-type arsenic source implant 48, a p-type body region 50 of boron, a n-type epi (1e16cm-2 to 8e16cm-2) 52 and n-type substrate 54.

In Figure 2 a cell pitch of about 1.1µm is shown, wherein the RESURF is achieved via the oxide deposited and then etched to a pre-defined depth. The join between the in-trench etched oxide and the gate oxide is critical and should be smooth.

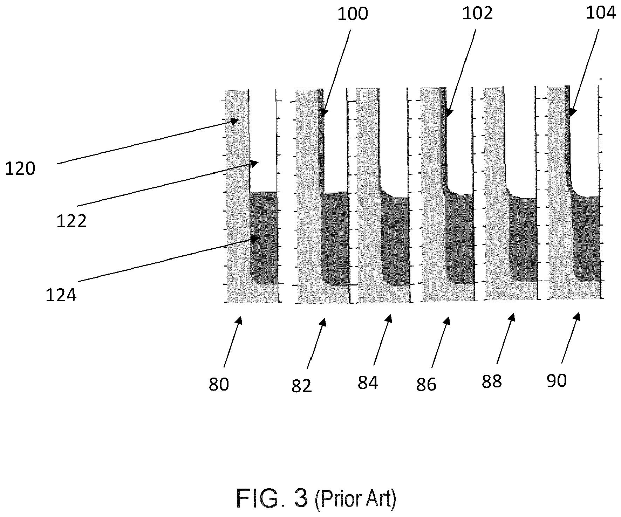

Creating such a known device comprises the following steps, as shown in Figure 3:
- step 80: within an n-type epi 120, etch a trench, deposit an oxide and etch back to required depth, wherein a trench region 122 and a thick deposited oxide 124 are created
- step 82: grow a first sacrificial oxide layer 100
- step 84: etch the first sacrificial oxide layer, deposit a first tetraethyl orthosilicate (TEOS) layer of about 100nm and isotopically etch
- step 86: grow a second sacrificial oxide layer 102
- step 88: etch the second sacrificial oxide layer, deposit a second TEOS layer of about 100nm and isotopically etch
- step 90: grow a gate oxide 104

This results in a nice smooth join between the deposited oxide and the gate oxide.

The trench width is about 0.60 µm, as for deep oxide trench RESURF the width of the oxide layer (layer 124 in Figure 3) in the trench determines the breakdown voltage for a given cell pitch. In this way an optimal MESA width (cell pitch - trench width) can be determined for the specified 0.60 µm trench width.

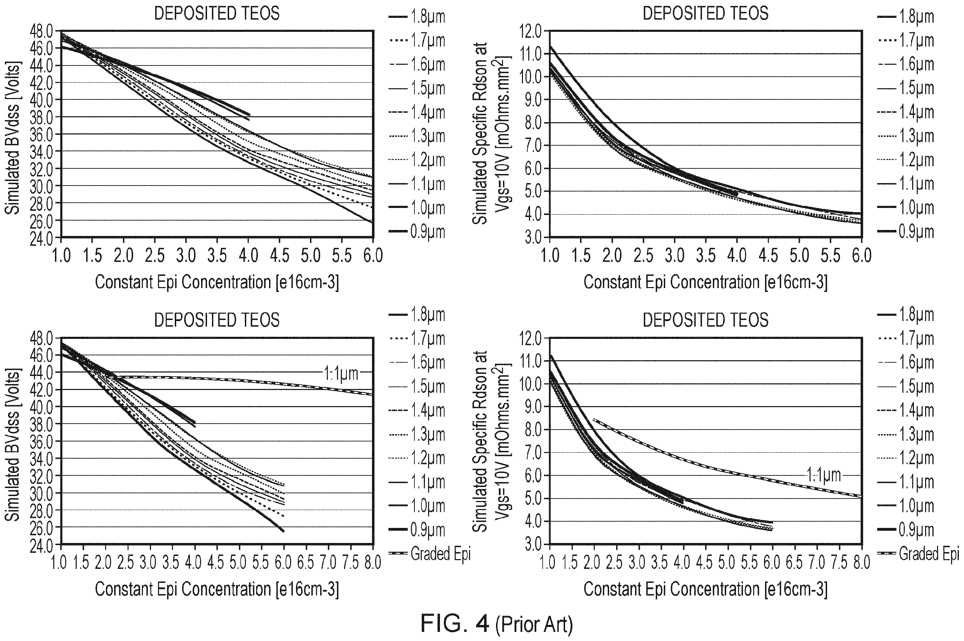

As shown in Figure 4 a typical 1.5µm deep pillar super junction Rspec for a 40V rated technology would be in the region of 9mOhms.mm². The above simulation shows that level of performance can be achieved but to achieve something >30% less would be difficult unless a cell pitch < 0.9µm is used. However, this would incorporate a dynamic Qgd Figure of Merit (FoM) > 2 x that of a 1.5µm cell pitch, which is unacceptable.

The top two graphs show uniformly doped epi silicon and how the breakdown voltage (BVdss) and Specific on-State Resistance (Rdson) varies with constant epi silicon concentration. The legend on the right-hand side of each plot indicates the cell pitch.

The bottom two graphs are the same as the top two graphs but include a graded epi profile: This is the 1.1µm labelled line showing that the breakdown voltage (BVdss) shows a flatter trajectory with epi doping.

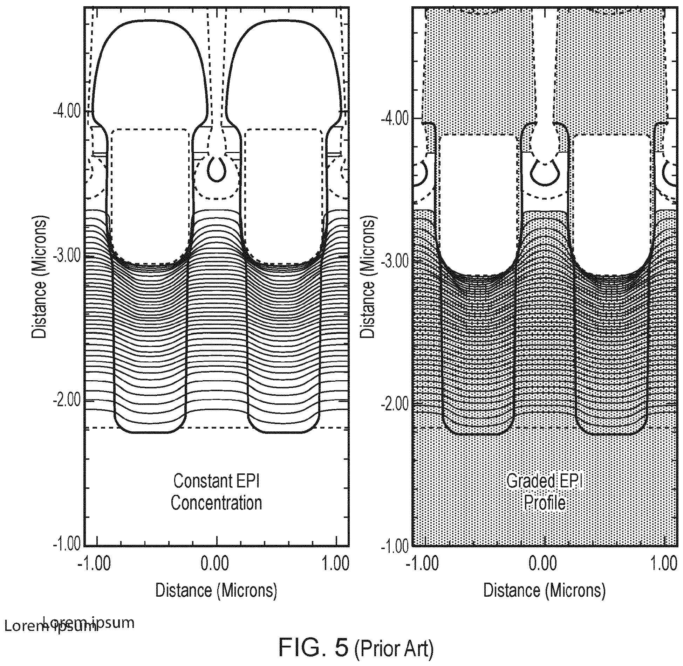

A known device is shown in Figure 5. An improvement would be to grade the epi profile from high doping at the channel to low doping at the substrate. Grading the epi, results in an improvement to the specific Rdson, but the dynamic Qgd FoM is still 1.5 x greater than that of a 1.5µm super junction with deep p-type pillars.

A problem of such RESURF devices, as known in the art, is that it is not possible to achieve a very low drain-source on resistance (Rdson) without using very narrow cell pitch and/or high simple gate charge (Qg) structures.

### SUMMARY

Various example embodiments are directed to the disadvantage as described above and/or others which may become apparent from the following disclosure.

According to an embodiment of this invention a method of creating a semiconductor device comprises the steps:
- etch a trench within an n-type epi, deposit an oxide and etch back to a first depth, wherein a trench region and a thick deposited oxide are created;
- grow a first sacrificial oxide layer;
- etch the first sacrificial oxide layer, deposit a first tetraethyl orthosilicate (TEOS) layer, etch isotopically, wherein a first oxide profile is created;
- grow a second sacrificial oxide layer;
- etch the second sacrificial oxide layer, deposit a second TEOS layer, etch isotopically, wherein a second oxide profile is created;
- grow a gate oxide;
- deposit a nitride on the gate oxide, the nitride comprising a first lateral part, a second lateral part and a vertical part, wherein the second lateral part is thicker than the first lateral part;
- etch a spacer by removing fully the first lateral part and removing partly the second lateral part;
- perform a thermal oxidation, wherein a thermal oxide region is created, since the oxide is extended at the position of the first lateral part of the nitride, since the nitride bends upwards;
- remove the nitride;
- depose a gate electrode polysilicon, create a screen oxide layer on the top of the gate electrode polysilicon.

The thickness of the first TEOS layer can be about 100 nm and the thickness of the second TEOS layer can be about 100 nm.

The oxide grow in the step of performing the thermal oxidation, ad described above, can be in a range from 200nm to 800nm, preferably 500nm.

The gate electrode polysilicon is of n-type and doped with phosphorus.

The screen oxide layer can be a 400nm implant.

The invention also relates to a semiconductor device created by the method as described above.

According to an embodiment of the invention, a semiconductor device comprises a gate electrode, the gate electrode comprising an upper side and a bottom side, a dielectric oxide on the upper side of the gate electrode and a deposited oxide on the bottom side of the gate electrode, wherein the deposited oxide has a first width. The deposited oxide could be also a thermally grown oxide. The dielectric oxide is a layer, usually oxide, that separates two electrodes. The dielectric oxide separates the gate electrode from the source electrode. The deposited oxide usually separates the gate electrode from the drain electrode. The deposited oxide comprises a thermal oxide region, wherein the thermal oxide region has a second width, wherein the second width of the thermal oxide region is broader than the first width of the deposited oxide.

The semiconductor device further comprises a body region of p-type, an epi of n-type and a substrate of n-type.

According to an embodiment of the invention a different semiconductor device, a second semiconductor device comprises two semiconductor devices as described above. The distance between the thermal oxide regions of these two semiconductor devices is smaller than the distance between the gate electrodes of these two semiconductor devices, and the distance between the thermal oxide regions of these two semiconductor devices is smaller than the distance between the deposited oxides of these two semiconductor devices.

The semiconductor device as described above, the semiconductor device having a thick, bulbous oxidations, which is referred as the thermal oxide region, secures a low Rdson.

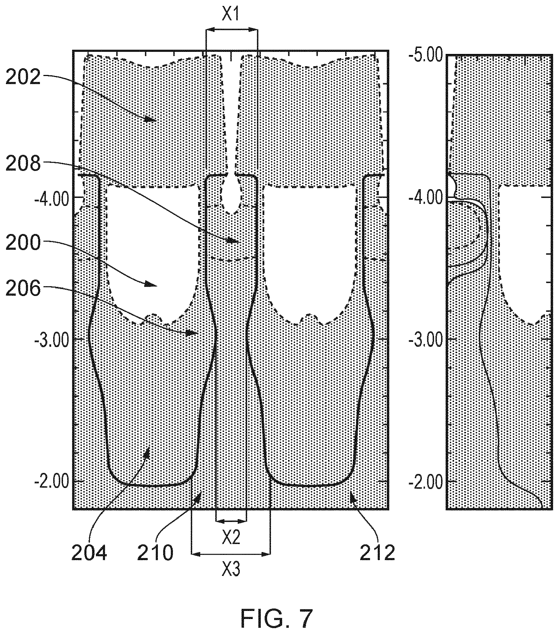

The combination of deposited oxide in a deep trench and an oxidation of silicon within that trench to locally thin the MESA distance between trenches (X2 in Figure 7) enables the epi silicon doping to be greater than in the location shown by X3 in Figure 7). This enables better RESURF, which in-turn results in a lower on-state resistance (Rdson) for the same breakdown voltage (BVdss), without having to reduce cell pitch. As the distance labelled X1 in Figure 7 is greater than X2 in Figure 7, then the source metallisation contact is also not being restricted as would have been the case if X1 was equal to X2.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 shows a known semiconductor device;
Figure 2 shows a known semiconductor device;
Figure 3 shows method steps for creating a known semiconductor device;
Figure 4 shows diagrams of breakdown voltages and Rdson's of the known semiconductor devices;
Figure 5 shows a known semiconductor device with constant and graded epi profiles;
Figure 6 shows a method for creating a semiconductor device according to an embodiment of the invention;
Figure 7 illustrates a semiconductor device according to an embodiment of the invention;
Figure 8 illustrates diagrams of breakdown voltages and Rdson's of a semiconductor device according to an embodiment of the invention;
Figure 9 illustrates diagrams of breakdown voltages and Rdson's of a semiconductor device according to an embodiment of the invention;
Figure 10 illustrates a semiconductor device according to an embodiment of the invention with graded epi profiles for the cell pitch of 1.10µm and for the cell pitch of 1.30 µm.

### DETAILED DESCRIPTION

According to an embodiment of the invention, a method comprises a step of a further in-trench oxidation that reduces the dynamic Qg FoM, without adversely affecting the specific Rdson (Rspec).

The method steps to achieve this embodiment is shown in Figure 6. The method comprised the following steps:
- step 80: within an n-type epi 120, etch a trench, deposit an oxide and etch back to required depth, wherein a trench region 122 and a thick deposited oxide 124 are created
- step 82: grow a first sacrificial oxide layer 100
- step 84: etch the first sacrificial oxide layer, deposit a first tetraethyl orthosilicate (TEOS) layer of about 100nm and isotopically etch, wherein a first oxide profile 130 is created
- step 86: grow a second sacrificial oxide layer 102
- step 88: etch the second sacrificial oxide layer, deposit a second TEOS layer of about 100nm and isotopically etch, wherein a second oxide profile 132 is created
- step 90: grow a gate oxide 104
- step 92: deposit a nitride 106 of the required thickness and then etch a spacer by removing the nitride from above the thick deposited oxide in the trench; only etching a lateral nitride, not a vertical nitride; the upper part nitride 134 is also etched but because it is thicker, some of the upper part nitride 134 is still remaining
- step 94: perform a thermal oxidation which extends the oxide at where the nitride is etched since the nitride will bend upwards; in this example embodiment 400 nm and 600 nm have been utilized for this submission range of 400nm-600nm oxide grow; it is possible to use any value from a range from 200nm to 800nm; in a preferred embodiment 500nm is used; 200nm provides a low resistance, 800nm provides a good gate range charge;
- step 96: remove entirely the nitride, depose a gate electrode polysilicon 140 of n-type, doped with phosphorus, create a screen oxide layer 142 on the top of the gate electrode polysilicon 140 which screen oxide layer can be a 400nm implant.

A semiconductor device created by the above described method is shown in Figure 7.

Such a semiconductor device, according to an embodiment of the invention, comprises: a gate electrode 200, made as a polysilicon electrode, a dielectric oxide 202 on the upper side of the gate electrode 200, a deposited oxide 204 on the bottom side of the gate electrode 200, and thermal oxide region 206. The thermal oxide region 206 is made in a shape of a beard beak. The dielectric oxide 202 isolates the gate electrode 200 from the source metallization. The semiconductor device further comprises a body region 208 of p-type, an epi 210 of n-type and a substrate 212 of n-type. The dielectric oxide 202 is an insulating layer dielectric (ILD), that separates two electrodes. The ILD can be an oxide. The dielectric oxide separates the gate electrode from the source electrode. The deposited oxide 204 usually separates the gate electrode from the drain electrode.

As shown in Figure 7, the shape of the deposited oxide 204 is such that enables a lower Rdson. Three relevant distances are shown in Figure 7 as X1, X2 and X3.

The distance X2 is smaller than the distance X1 and the distance X3. This enables the epi doping in the region of X1 to be much larger than in the region of X3, resulting in lower specific Rdson's.

The distance X1 is greater than distance X2 so the contact is much simpler than the contact in the case with the MESA width being the same as the X2 distance.

The distance X3 is greater than X2 and X1, which enables the current to spread as it passes the low resistance region X2. This is an advantage over the dual trench etch variant.

The oxidised birds-beak is much thicker and a much lower dynamic Qg will be achieved.

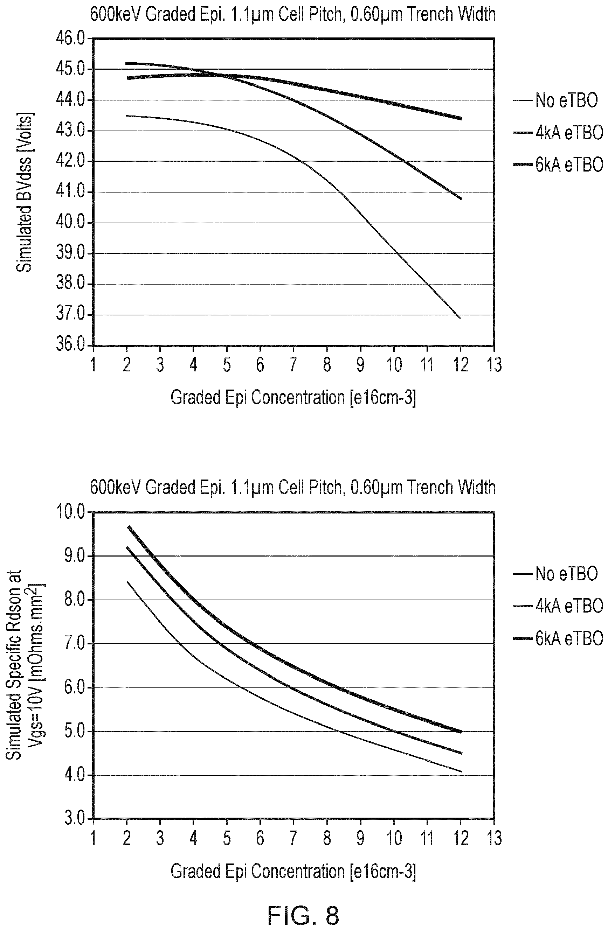

Comparing the 400nm and 600nm extended thick barrier oxide (eTBO) with the previous deep trench oxide structure can be done with a 1.1µm cell pitch (0.5µm MESA width) and the results are show in Figure 8.

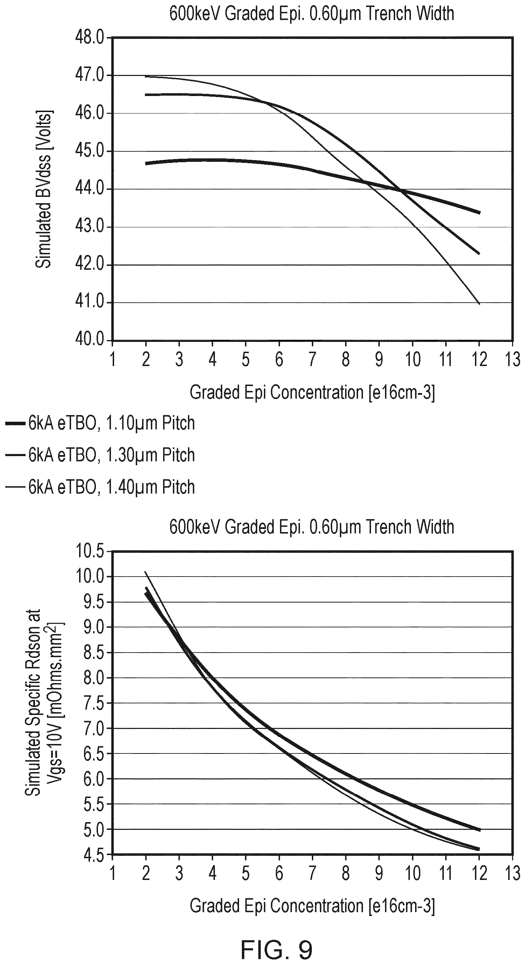

To achieve the maximum benefit, the eTBO should be maximised as much as possible as the BVdss window as a function of the graded epi concentration is much wider. For a given epi concentration, there is an impact upon specific Rdson (Rspec). for the same BVdss, the reduction compared to a 1.5µm super junction is in the region of 35%. The dynamic Qgd FoM has also improved significantly but is still 10% higher than an equivalent 1.5µm super junction with p-type pillars. The final simulation is to investigate if a wider cell pitch can be utilized so that a better dynamic switching performance can be achieved and what would be the impact upon specific Rdson (Rspec). The results are shown in Figure 9.

Firstly, by increasing the cell pitch, for any given epi concentration, there is an improvement is specific Rdson (Rspec) as there is less pinching of the conductive current between the 'bulges' of the trench. For BVdss, when you increase cell pitch (fixed trench width) there is still a wide window, but it is not as flat as for the 1.1µm cell pitch. Overall, the dynamic Qg FoMs for a 1.3µm pitch are very like that of a 1.5µm super junction and for a 1.4µm pitch they are slightly better. Optimisation of the trench depth may offer further improvements.

Overall, by incorporating a two-stage thick oxide process, a low Rdson 40V technology can be achieved with more than 35% Rspec improvement (compared to 1.5µm super junction) and with similar dynamic Qg figure of merit (FoM) performance.

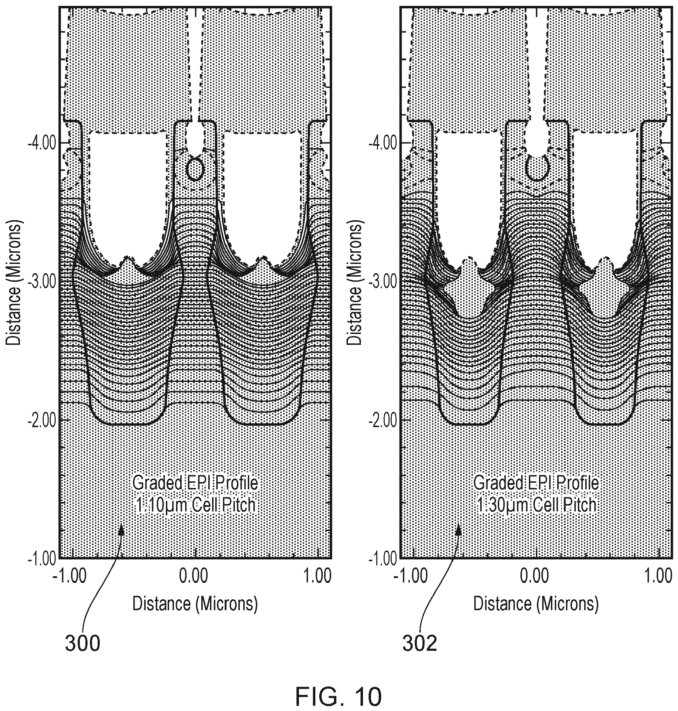

An embodiment of the invention is shown in Figure 10. A further improvement can be achieved by increasing cell pitch further and by incorporating a wider trench width, so that the gap between the oxide bulges is minimized. This would be ideal for a low Qg FoM platform. This and other options will be incorporated into a mask set. Two embodiments of the invention are shown in Figure 10: a first device 300 with a cell pitch of 1.10 µm and a second device 302 with a cell pitch of 1.30 µm. Both devices, the first device 300 and the second device 302 can have a graded epi profile.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A method of creating a semiconductor device, the method comprising the steps:
- etch a trench within an n-type epi, deposit an oxide and etch back to a first depth, wherein a trench region and a thick deposited oxide are created;
- grow a first sacrificial oxide layer;
- etch the first sacrificial oxide layer, deposit a first tetraethyl orthosilicate (TEOS) layer, etch isotopically, wherein a first oxide profile is created;
- grow a second sacrificial oxide layer;
- etch the second sacrificial oxide layer, deposit a second TEOS layer, etch isotopically, wherein a second oxide profile is created;
- grow a gate oxide;
- deposit a nitride on the gate oxide, the nitride comprising a first lateral part, a second lateral part and a vertical part, wherein the second lateral part is thicker than the first lateral part;
- etch a spacer by removing fully the first lateral part and removing partly the second lateral part;
- perform a thermal oxidation, wherein a thermal oxide region is created, since the oxide is extended at the position of the first lateral part of the nitride, since the nitride bends upwards;
- remove the nitride;
- depose a gate electrode polysilicon, create a screen oxide layer on the top of the gate electrode polysilicon.

2. A method of creating a semiconductor device as claimed in claim 1, wherein the thickness of the first TEOS layer is about 100 nm and the thickness of the second TEOS layer is about 100 nm.

3. A method of creating a semiconductor device as claimed in claim 1 or 2, wherein the oxide grow in the step of performing the thermal oxidation is in a range from 200nm to 800nm, preferably 500nm.

4. A method of creating a semiconductor device as claimed in any of claims 1 to 3, wherein the gate electrode polysilicon is of n-type and doped with phosphorus.

5. A method of creating a semiconductor device as claimed in any of claims 1 to 4, wherein the screen oxide layer is a 400nm implant.

6. A semiconductor device created by a method as claimed in any of the previous claims.

7. A semiconductor device comprising:
- a gate electrode, the gate electrode comprising an upper side and a bottom side,
- an insulating layer dielectric on the upper side of the gate electrode,
- a deposited oxide on the bottom side of the gate electrode, wherein the deposited oxide has a first width,
- wherein the deposited oxide comprises a thermal oxide region, wherein the thermal oxide region has a second width,
wherein the second width of the thermal oxide region is broader than the first width of the deposited oxide.

8. A semiconductor device as claimed in claim 7, wherein the insulating layer dielectric is an oxide.

9. A semiconductor device as claimed in claim 7 or 8, the semiconductor device further comprising a body region of p-type, an epi of n-type and a substrate of n-type.

10. A second semiconductor device, the second semiconductor device comprising two semiconductor devices as claimed in any of claims 6 to 9, wherein the distance between the thermal oxide regions of these two semiconductor devices is smaller than the distance between the gate electrodes of these two semiconductor devices, and wherein the distance between the thermal oxide regions of these two semiconductor devices is smaller than the distance between the deposited oxides of these two semiconductor devices.
